Europäisches Patentamt

European Patent Office

Office européen des brevets

(19)

(11) Veröffentlichungsnummer : **0 042 522 B2**

(12) **NEUE EUROPÄISCHE PATENTSCHRIFT**

(45) Veröffentlichungstag der neuen Patentschrift :
26.04.89

(51) Int. Cl.⁴ : **G 11 B   5/09**// G11B20/18, G06F11/10

(21) Anmeldenummer : 81104357.9

(22) Anmeldetag : 05.06.81

(54) System zur Verarbeitung und/oder Übertragung von PCM Signalen.

(30) Priorität : 16.06.80 DE 3022541

(43) Veröffentlichungstag der Anmeldung :
30.12.81 Patentblatt 81/52

(45) Bekanntmachung des Hinweises auf die Patenterteilung : 03.10.84 Patentblatt 84/40

(45) Bekanntmachung des Hinweises auf die Entscheidung über den Einspruch : 26.04.89 Patentblatt 89/17

(84) Benannte Vertragsstaaten :
AT BE CH DE FR GB IT LI LU NL SE

(56) Entgegenhaltungen :
EP-A- 0 026 050
EP-A- 0 029 226
DE-A- 2 240 057
DE-A- 2 915 459
DE-A- 2 946 702
NL-A- 7 900 826
IEEE TRANSACTIONS ON COMMUNICATIONS TECHNOLOGY, Band COM-19, Nr. 5, Oktober 1971 NEW YORK (US) G. DAVID FORNEY Jr. "Burst-correcting for the classic bursty channel" Seiten 772-781
JOURNAL OF THE AUDIO ENGINEERING SOCIETY, Band 28, Nr. 4, April 1980 NEW YORK (US) "Consumer use PCM encoder-decoder 1979-6. Electronic industries association of Japan technical file of the setreo technical committee and the video technical committee STC-007", Seiten 260-265
Journal of the Audio Engineering Society, Band 27, Nr. 12, Dezember 1979, pp. 975-981, "A Long-Play Digital Audio Disk System"
IEEE Transactions on Communications, Band COM-26, März 1978, pp. 406-408, "A Simple Interleaver for Use with Viterbi Decoding"

(73) Patentinhaber : TELEFUNKEN Fernseh und Rundfunk GmbH
Göttinger Chaussee 76
D-3000 Hannover 91 (DE)

(72) Erfinder : Scholz, Werner, Dipl.-Ing.
Osterstrasse 20
D-3007 Gehrden (DE)

(74) Vertreter : Einsel, Robert, Dipl.-Ing.
TELEFUNKEN Fernseh und Rundfunk GmbH Göttinger Chaussee 76
D-3000 Hannover 91 (DE)

**Beschreibung**

Die Erfindung betrifft ein System zur Verarbeitung und Übertragung von PCM-Signalen, insbesondere von Tonsignalen, die im PCM-Format auf einem Speichermedium aufgezeichnet und von diesem wiedergegeben werden.

Es sind Verfahren bekannt, Ton- oder Fernsehsignale als pulscodemodulierte Signale auf einem Aufzeichnungsmedium, z. B. einem Magnetband oder einer Platte, aufzuzeichnen. Es ist zwar prinzipiell möglich, aufzuzeichnende oder zu übertragende Daten einer einfachen Pulscodemodulation zu unterziehen und diese codierten Daten zu übertragen bzw. aufzuzeichnen. Aber nur bei einem idealen Übertragungskanal wäre ein derartiges Modulationsverfahren ausreichend, um hohe Ansprüche an die Übertragungsqualität zu erfüllen.

Ein Magnetband, eine Platte oder eine Übertragungsstrecke sind in der Realität nicht ideal, sondern verfälschen das zu verarbeitende Signal. Eine Reproduzierbarkeit ist daher nur ungenügend gewährleistet. Die Übertragungsstrecke, das Band oder die Platte werden im folgenden als Kanal bezeichnet. Der Kanal ist ein störbehaftetes Medium, das die Signale im allgemeinen so verfälscht, dass eine Übertragung ohne eine Datensicherung nicht möglich ist. Es gibt verschiedene Möglichkeiten zur Datensicherung, die teilweise allein oder zusammen mit anderen angewendet werden.

Ein übliches Verfahren arbeitet folgendermassen : Die zu übertragenden Daten werden seriell in Blöcke gleicher Anzahl von Datenwörtern aufgeteilt. Jeder Datenblock wird um ein sogenanntes CRC-Datenwort sowie ein Synchronisationswort ergänzt. Das CRC-Wort (cyclic redundancy check) ist ein zyklischer Code, der über eine Polynomdarstellung gewonnen wird. Auf diese Weise können Fehler des mit einem CRC-Datenwort abgeschlossenen Blockes erkannt werden. Derartige CRC-Datenwortschaltungen sind als integrierte Schaltkreise handelsüblich (z. B. Fairchild 9401). Zur Fehlerkorrektur kann jedem Block noch ein sogenanntes Paritätswort angefügt werden, so dass zusammen mit dem CRC-Datenwort eine Erkennung und eine Korrektur fehlerbehafteter Daten ermöglicht ist. Damit eine Korrektur durchgeführt werden kann, müssen zusammengehörende Daten- und Paritätswörter in verschiedenen Blöken übertragen werden, denn schon ein einziger Bitfehler macht einen vollständigen Block zunächst einmal unbrauchbar.

Es gibt daher Vorschläge, wie sie in der DE-OS 2 240 057 wiedergegeben sind, die gesamten Daten nicht in der ursprünglichen Reihenfolge über den Kanal zu geben, sondern die einzelnen Datenwörter abwechselnd um eine bestimmte Dauer oder um ein Vielfaches davon zu verzögern und die verzögerten und unverzögerten Datenwörter nacheinander über den Kanal zu geben. Dies wird als Verschachtelung oder Interleaving bezeichnet.

Bei Aufzeichnungsgeräten auftretende Störungen wirken vorzugsweise als sogenannte Burstfehler auf während der Übertragung aufeinanderfolgende Datenwörter bzw. Blöcke. Diese werden jedoch durch das interleaving-Verfahren im Ergebnis wieder auseinandergezogen, so dass die Störung bei der endgültigen richtigen Zusammenfügung der Datenwörter in der ursprünglichen Reihenfolge gestreut wird. Die gestreuten Fehler können dann durch Paritätsvergleich oder über eine Interpolationsschaltung eliminiert werden. Eine derartige Verschachtelungsmethode ist in einem Bericht der Audio Engineering Society, 64. Konvention vom 2. November bis 5. November 1979 in New York City veröffentlicht. Eine solche Verschachtelungsmethode erlaubt es, Störstellen aus den Signalen grösstenteils zu entfernen. Manche Störungen des Kanals verursachen jedoch in dem wiederzugebenden Signal Fehlerstellen, die sich noch über mehrere benachbarte Datenwörter erstrecken können, so dass eine Interpolation derartiger Fehler nur schwerlich möglich ist.

Die Anmelderin weist auf die europäische Patentanmeldung Nr. 81 104 356.1 hin, in der vorgeschlagen ist, aufeinanderfolgende Datenwörter eines PCM-Signals eingangsseitig vor Bildung eines ersten Korrekturwortes zusätzlich zu verschachteln und ausgangsseitig nach der letzten Korrektur zu entschachteln und einer zusätzlichen Interpolationsschaltung zuzuführen. Aus dem Journal of the Audio Engineering Society, 1979 December, Volume 27, No. 12, pp. 975-981, « A Long-Play Digital Audio Disk System » ist ein digitales Signalverarbeitungssystem bekannt, bei dem als PCM-Signale vorliegende Tonsignale auf der Eingangsseite eines Übertragungskanals verschachtelt werden. Aus dieser Druckschrift ist entnehmbar, daß ankommende Datenwörter L und R mit einem Verschachtelungsabstand von 16 Datenwörtern verschachtelt werden, während aus den Datenwörtern gebildete Paritätswörter P und Q um 32 bzw. 35 Datenwörter verschachtelt werden. Da der Abstand der verschachtelten Datenwörter stets gleich ist, gelingt es nicht, eine bessere Fehlerzerstreuung zur Vermeidung von Doppelfehlern zu erreichen.

Aufgabenstellung :

Der Erfindung liegt die Aufgabe zugrunde, bei einem System zur Verarbeitung und Übertragung von PCM-Signalen über einen Kanal die dabei auftretenden Fehler gegenüber bekannten Einrichtungen so zu zerstreuen, dass eine Häufung von Doppelfehlern vermieden wird.

Die Erfindung wird durch die im Anspruch 1 angegebenen Merkmale gelöst. Weiterbildungen der Erfindung sind in den Unteransprüchen beschrieben.

Die Erfindung ermöglicht ohne zusätzlichen Aufwand gegenüber herkömmlichen Schaltungen eine verbesserte Fehlerstreuung. Die Anordnung der Speicher, die zur Verschachtelung der Datenwörter erforderlich sind, auf die Ein- und die Ausgangsseite des Kanals ergibt eine für die Datenwörter mit unterschiedlichen Verzögerungs-zeitabständen aufgebaute Verschachtelungsein-richtung. Die verbesserte Fehlerstreuung vermei-det das Auftreten einer Häufung von Doppelfehlern bei bestimmten Fehlerabständen, so dass die fehlerverdeckende Wirkung der Interpolation an Stellen hoher Fehlerdichte verbessert wird.

Beim herkömmlichen Verfahren treten Doppel-fehlerstellen infolge gleicher Verschachtelungs-abstände immer gleich mehrfach auf. Bei der erfindungsgemässen Verschachtelung kann bei zwei gestörten Blöcken, die sich in einem bestimmten Abstand befinden, immer höchstens ein Doppelfehler entstehen. Alle anderen mit einer Fehlermarkierung versehenen Datenwörter der beiden gestörten Blöcke treten nach der Entschachtelung einzeln auf, so dass die Interpolation erleichtert und die fehlerverdeckende Wirkung verbessert ist.

Die Erfindung wird nachstehend anhand eines Ausführungsbeispiels näher erläutert. Es zeigen :

Fig. 1 einen prinzipiellen Aufbau einer PCM-Aufnahmeeinrichtung,

Fig. 2 einen prinzipiellen Aufbau einer PCM-Wiedergabeeinrichtung,

Fig. 3 eine bekannte Verschachtelungseinrichtung,

Fig. 4 eine Darstellung zur Verdeutlichung der Wirkungsweise einer bekannten Verschachtelungseinrichtung,

Fig. 5 eine Verdeutlichung des Entstehens von Doppelfehlern bei einer bekannten Verschachtelungseinrichtung,

Fig. 6 eine erfindungsgemässe Anordnung einer Verschachtelungseinrichtung,

Fig. 7 eine Darstellung der Wirkung von Fehlern bei einer erfindungsgemässen Einrichtung,

Fig. 8 eine andere erfindungsgemässe Ver-schachtelungsanordnung der Aufnahmeseite,

Fig. 9 eine Darstellung zur Wirkungsweise der Einrichtung nach Fig. 8,

Fig. 10 ein Diagramm zur Darstellung der Ermittlung des Paritätswortes,

Fig. 11 eine erfindungsgemässe Verschachtelungsanordnung auf der Wiedergabeseite.

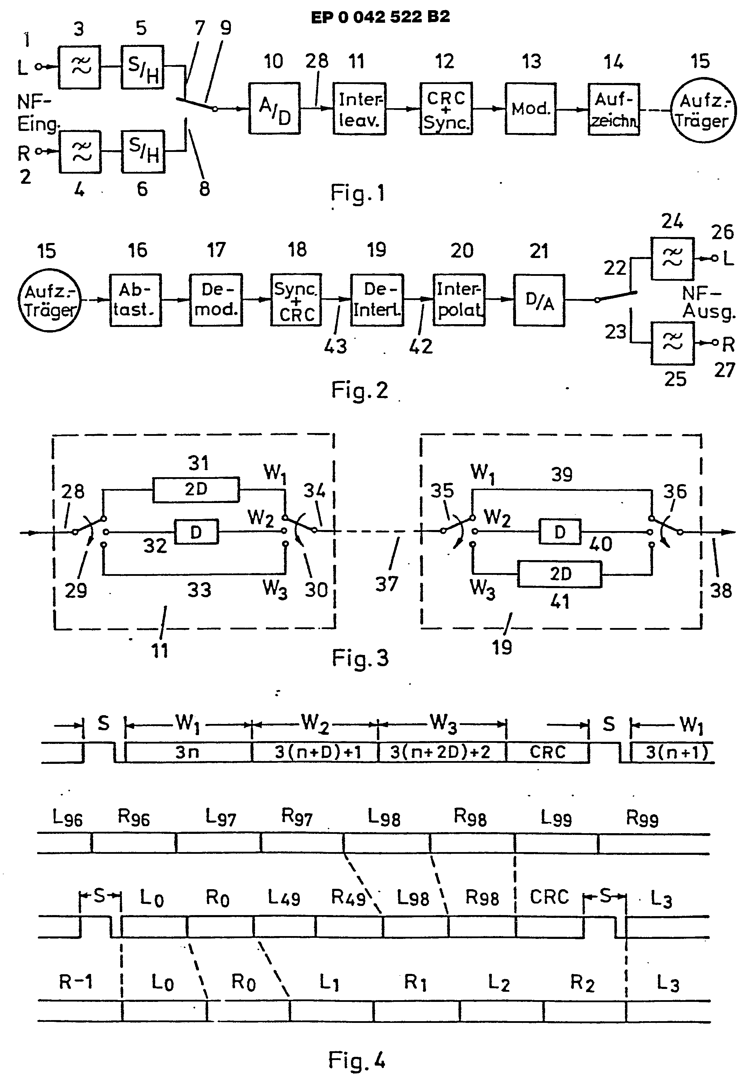

Das in Fig. 1 dargestellte Aufnahmesystem zeigt in vereinfachter Form, wie die Signale zweier Tonkanäle so verarbeitet werden können, dass sie über einen sogenannten Kanal gegeben werden können. Die Eingänge 1 und 2 stellen die niederfrequenten Eingänge der zwei Tonkanäle links und rechts dar. Wir beschränken uns hier auf die Betrachtung zweier Tonkanäle, obwohl es sich auch beispielsweise um die Übertragung von 4 voneinander unabhängigen NF-Kanälen handeln könnte.

In jedem der beiden Verarbeitungskanäle liegt ein Antialiasingfilter 3 und 4. Das Antialiasingfilter verhindert die Verfälschung des Signals durch den Abtastvorgang. An die beiden Antialiasingfilter 3 und 4 schliessen sich die Sample and Hold-Schaltungen 5 und 6 an. Alle nachfolgenden Schaltkreise einschliesslich der Sample and Hold-Schaltungen 5 und 6 werden von einem gemeinsamen Taktgenerator gesteuert, der nicht dargestellt ist. Die beiden Ausgänge der im Ge-gentakt betriebenen Sample and Hold-Schaltun-gen 5 und 6 werden an die zwei Klemmen 7 und 8 eines Umschalters 9 geführt, der immer gerade den Abtastwert durchschaltet, der gehalten wird, während im anderen Kanal die Abtastung erfolgt. Durch diesen Umschalter 9 wird erreicht, dass die jeweiligen Abtastwerte der Kanäle links und rechts in serieller Reihenfolge abwechselnd dem nachfolgenden Analog/Digital-Wandler 10 zugeführt werden. Dem Analog/Digital-Wandler ist die sogenannte Interleaving-Schaltung 11 nachgeschaltet, in der die in richtiger Reihenfolge ankommenden Datenwörter verschachtelt werden. Die verschachtelten Datenwörter werden in Gruppen von z. B. je drei Abtastwertepaaren zusammengefasst. In einer weiteren Schaltung 12 werden jeder Gruppe ein CRC-Wort und Synchronisationsbits zugefügt. Dieses blockweise codierte Digitalsignal wird auf einen Modulator 13 geführt, von dem das modulierte Signal auf den Übertragungskanal gegeben wird, der hier z. B. aus einem Aufzeichnungsgerät 14 und einer Abtasteinrichtung 16 besteht. Dabei kann der Aufzeichnungsträger 15 ein Magnetband oder eine Platte sein. Der Übertragungskanal 14, 15, 16 kann aber auch durch ein Kabel oder eine Funkstrecke gebildet werden.

Fig. 2 zeigt eine Wiedergabeeinrichtung zur Verarbeitung eines von einem Aufzeichnungsträger 15 abgetasteten PCM-Signals. Das von einer Abtasteinrichtung 16 gewonnene Signal wird einem Demodulator 17 zugeführt. Vom Demodulator 17 gelangt das PCM-Signal auf eine Schaltung 18, in der Synchronisations- und CRC-Wörter ausgewertet werden. Ergibt die CRC-Auswertung eine Fehlermeldung, so werden sämtliche Datenwörter des betreffenden Blocks mit einer Fehlermarkierung versehen. Es folgt die Deinterleavingschaltung 19, die die auf der Aufnahmeseite verschachtelten Datenwörter entschachtelt. Mit Fehlermarkierung versehene Datenwörter werden anschliessend in der Interpolationsschaltung 20 durch den Mittelwert aus den benachbarten Datenwörtern ersetzt. Das jetzt entstandene korrigierte und in richtiger Reihenfolge seriell vorliegende PCM-Datensignal wird auf den Digital/Analog-Wandler 21 gegeben, von dem es abwechselnd auf die beiden Niederfrequenzkanäle 22 und 23 mit den Tiefpassfiltern 24 und 25 gegeben wird. An den Klemmen 26 und 27 ist dann das niederfrequente Signal zur weiteren Verarbeitung abgreifbar. Die Interpolation kann auch im analogen Bereich, d. h. hinter dem Digital/Analog-Wandler, erfolgen.

Fig. 3 zeigt die Funktionsweise der Interle-aving- und Deinterleavingschaltungen. Die Interle-avingschaltung 11 enthält zwei Umschalter 29 und 30, die synchron Eingang 28 und Ausgang 34 nacheinander mit den Strecken 31, 32 und 33 verbinden. Dabei enthält die Strecke 31 eine Einrichtung zur Verzögerung des ankommenden Signals um eine Dauer 2D. Das ist die Dauer von 2D aufeinanderfolgenden Datenblöcken mit z. B.

D = 16. Die Strecke 32 enthält eine Verzögerung um die Dauer D, die Strecke 33 enthält keine Verzögerung. Auf der Wiedergabeseite ist die Deinterleavingschaltung 19 in umgekehrter Anordnung aufgebaut. Es sind wiederum zwei Umschalter 35 und 36 vorhanden, die synchron in gleicher Weise wie die Schalter 29 und 30 umschalten. Am Eingang 37 ankommende Datenwörter werden abwechselnd auf die Strecken 39, 40 oder 41 gegeben, wobei die Strecke 39 keine Verzögerung, die Strecke 40 eine Verzögerung der Dauer von D Datenblöcken und die Strecke 41 eine Verzögerung der Dauer von 2D Datenblöcken enthält. Die am Eingang 28 der Interleavingschaltung 11 ankommenden Datenwörter werden zwar zunächst für die Übertragung unterschiedlich verzögert. Durch die Deinterleavingschaltung 19 werden die Verzögerungen der einzelnen Datenwörter so ergänzt, dass die Gesamtverzögerung aller Datenwörter vom Eingang 28 bis zum Ausgang 38 gleich ist. Diese Gesamtverzögerung hat hier die Dauer von 2D Datenblökken. In einem bevorzugten Beispiel ist D = 16. Die Verzögerung D hat also die Daten von 16 Datenblöcken mit jeweils 3 Abtastwertepaaren.

Das auf den Kanal 14, 15, 16 zu gebende Signal, das in der Interleavingschaltung 11 behandelt wurde und mit CRC- und Synchronisationswörtern versehen wurde, ist in Fig. 4 in der ersten Zeile dargestellt. Dieses Signal liegt am Ausgang des Blockes 12 von Fig. 1. Das Signal wird zunächst als sogenanntes NRZ-Signal (non return to zero) gebildet. Die Übertragung erfolgt blockweise mit den Abtastwertepaaren $W_1$, $W_2$ und $W_3$. Nach dem dritten Abtastwertepaar $W_3$ folgt das CRC-Wort und ein Synchronisationswort. Das CRC-Wort wird aus den drei vorhergehenden Abtastwertepaaren gebildet. In dem in Fig. 4, erste Zeile, angegebenen Bildungsalgorhythmus für die zu übertragenden Daten entspricht die Bezeichnung n der Blocknummer. Ein Block entspricht einer Dauer von drei Abtastintervallen eines Kanals (Fig. 4, zweite bis dritte Zeile). Das Abtastwertepaar $W_1$ hat die Numerierung 3n, im gleichen Block hat das Abtastwertepaar $W_2$ die Numerierung 3 (n + D) + 1, das Abtastwertepaar $W_3$ die Numerierung 3 (n + 2D) + 2. In Fig. 4, zweite Zeile, sind als Beispiel am Eingang 28 der Interleavingschaltung 11 ankommende Daten (L, R)$_{96-99}$ dargestellt. Jeder Abtastwert besteht aus einem Wort von 14 Bit, so dass die Abtastwertepaare $W_1$ bis $W_3$ jeweils aus einem Datenwort von 28 Bit bestehen.

Das CRC-Wort dient der Fehlererkennung. Zur Blocksynchronisierung dient das S-Signal. Bei einer Fehlermeldung durch die CRC-Schaltung 18 erhält jedes zu dem Block gehörende Wort eine Fehlermarkierung. Damit kann eine Korrektur durch Interpolation erfolgen. Durch die verschachtelte Übertragung (Interleaving) wird für eine Fehlerzerstreuung gesorgt, so dass für eine Interpolation Stützwerte vorhanden sind.

Fig. 4, Zeile 3, zeigt, in welcher Form die ankommenden Signale nach Durchlaufen der Interleavingschaltung 11 und der CRC- und Synchronisationsschaltung 12 am Modulator 13 ankommen. Gemäss Fig. 3 treten die Datenwörter am Ausgang 34 der Interleavingschaltung 11 für n = 0 in der Reihenfolge (L, R)$_0$, (L, R)$_{49}$ und (L, R)$_{98}$ auf, wobei eine angenommene Verzögerung D der Dauer von 16 Blöcken mit jeweils 3 Abtastwertepaaren entspricht. Die Reihenfolge der Abtastwerte ist daher ersichtlich verschachtelt worden. Fig. 4, vierte Zeile, zeigt die Wirkung der Entschachtelungsanordnung 19. Es ist ersichtlich, dass das am Ausgang 42 der Deinterleavingschaltung 19 ankommende Signal wieder in der ursprünglichen Reihenfolge vorliegt, aber mit einer scheinbaren Verzögerung von 2D, d. h. das Ausgangssignal der Gesamtschaltung ist gegenüber dem Eingangssignal um 2D Datenblöcke früher ausgesendet worden.

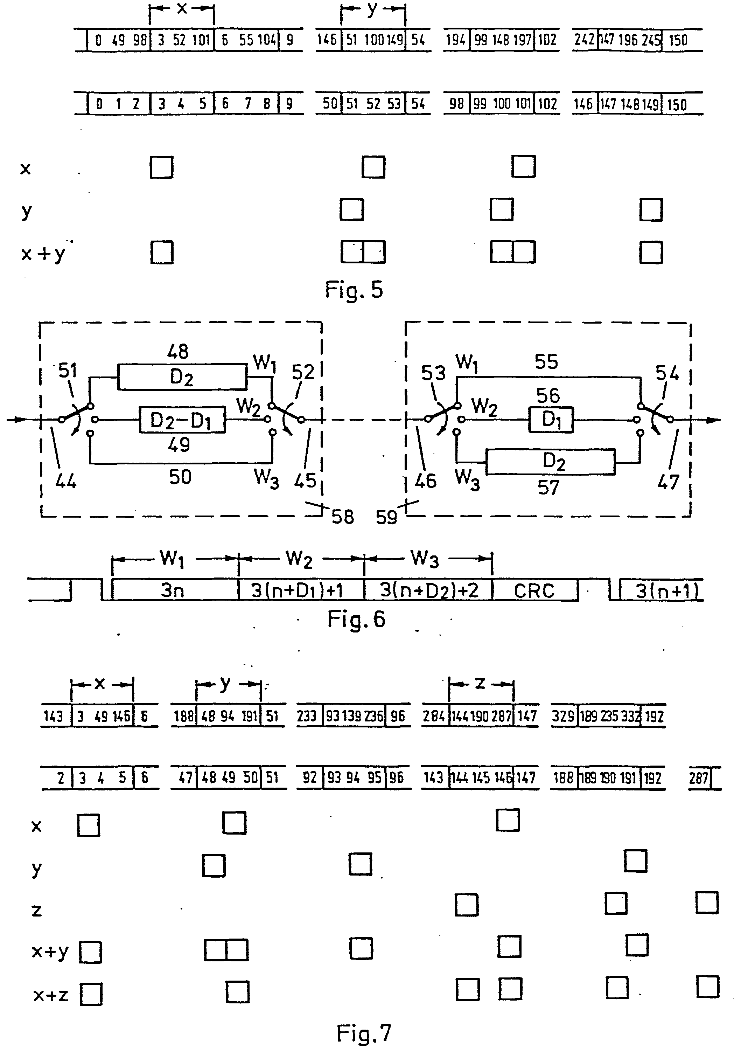

In Fig. 5 wird die Auswirkung von Störungen veranschaulicht. X oder Y seien gestörte Datenblöcke in einem Signal, das am Eingang 43 der Deinterleavingschaltung 19 ankommt. Durch die Entschachtelung werden die im Kanal 14, 15, 16 auf jeweils einen vollständigen Block wirkenden Fehler so gestreut, dass nach der Entschachtelung jeweils drei isolierte Datenwörter mit der Fehlermarkierung versehen sind. Diese jeweils markierten Datenwörter können durch die Interpolationsschaltung 20 ersetzt werden, ohne dass Fehler im Wiedergabekanal merkbar wären. Treten jedoch zwei Störungen X und Y im Abstand D auf, so sind hier gleich an zwei Stellen nach der Entschachtelung jeweils zwei aufeinanderfolgende Abtastwerte (Doppelfehler) mit einer Fehlermarkierung versehen. Die Korrektur eines derartigen Doppelfehlers durch Interpolation ist an sich schon wesentlich schwerer und unvollkommener durchführbar als bei einem Einzelfehler. Hier treten aber infolge gleicher Verschachtelungsabstände gleich zwei Doppelfehler kurz hintereinander auf.

Fig. 6 zeigt die erfindungsgemässe Anordnung einer Interleavingschaltung 58 und Deinterleavingschaltung 59. Die Verschachtelungseinrichtung enthält zwei synchron arbeitende Umschalter 51 und 52, die jeweils im Takt des Auftretens der Abtastworte Eingang 44 und Ausgang 45 an die Strecken 48, 49 oder 50 anlegen. Die Strecke 48 enthält eine Verzögerung um $D_2$, die Strecke 49 eine Verzögerung $D_2 - D_1$ und die Strecke 50 keine Verzögerung. Zwischen den Strecken 50 und 49 sowie 49 und 48 sollen unterschiedliche Verzögerungsdifferenzen bestehen. Man wählt z. B. $D_2 \cong 3 D_1$. Die entsprechende Entschachtelungsanordnung weist den Eingang 46 und den Ausgang 47 auf. Zwei synchron arbeitende Umschalter 53 und 54 schalten synchron mit dem Auftreten von Abtastworten den Eingang 46 und den Ausgang 47 auf die Strecken 55, 56 oder 57. Die Strecke 55 enthält dabei keine Verzögerung, die Strecke 56 eine Verzögerung um $D_1$ und die Strecke 57 eine Verzögerung um $D_2$. Auch hierbei ist die Verzögerungsdifferenz zwischen den Strecken 55 und 56 und den Strecken 56 und 57 unterschiedlich. Entsprechend Fig. 6, zweite Zeile, treten am Ausgang 45 die Abtastwertepaare in der Reihenfolge 3n, 3 $(n + D_1) + 1$ und 3 $(n + D_2) + 2$ auf. Die Gesamtverzögerungsdauer vom Eingang 44 bis zum Ausgang 47 beträgt für alle Abtastwertepaare genau $D_2$. Dies ergibt sich aus der Addition der Verzögerungsdauern der jeweiligen Strecken für die Abtastwertepaare $W_1$, $W_2$ und $W_3$. Bei dem in Fig. 7 angegebenen Beispiel entspricht die Verzögerungszeit $D_1$ der Dauer von 15 und $D_2$ der Dauer von 47 Blöcken zu je drei Abtastwertepaaren. Die Verzögerungsdauer $D_2$ ist damit etwa dreimal so gross wie die Verzögerungsdauer $D_1$.

Bei der Übertragung auftretende Fehlerstellen X, Y und Z am Eingang der Deinterleavingschaltung 59, die in der Zeile 1 der Fig. 7 dargestellt sind, werden nach der Entschachtelung so zerstreut, dass sie entsprechend Fig. 7, dritte, vierte oder fünfte Zeile, auftreten. Wenn die Fehlerstellen X, Y oder Z einzeln auftreten, so sind diese auf der Wiedergabeseite derart zerstreut, dass jeweils nur einzelne fehlermarkierte Wörter übrigbleiben, so dass eine Interpolation leicht ausführbar ist. Treten dagegen die Fehler X und Y zusammen auf, so ergibt sich gemäss Fig. 7, sechste Zeile, ein einmal auftretender Doppelfehler. Bei der Fehlerkombination X + Z entsprechend Fig. 7, siebte Zeile, tritt kein Doppelfehler auf. Die Störung X mit der Störung Y zusammen führt also nur zu einem echten Doppelfehler, während die Kombination von X und Z zwar ebenfalls zu zwei im gleichen Abtasttripel liegende Fehler führt, aber es ist dort kein echter Doppelfehler, so dass für die Interpolation dieser beiden Fehler noch ein ungestörter Stützwert zur Verfügung steht.

Bei der erfindungsgemässen Verschachtelung bestehen zwar mehr Möglichkeiten für die Bildung von Doppelfehlern. Zwei in einem bestimmten Abstand auftretende Störungen können aber immer nur zu höchstens einem Doppelfehler führen. Dagegen können zwei Störungen bei der Verschachtelung mit gleichem Abstand gemäss Fig. 3, 4, 5 auch zu zwei gleichzeitig auftretenden Doppelfehlern führen. Es ist durchaus möglich, dass bei einer Tonübertragung eine einzeln auftretende, nicht perfekt durchgeführte Fehlerbeseitigung durch Interpolation noch nicht wahrnehmbar ist, dass aber zwei unmittelbar aufeinanderfolgende derartige Störungen bereits ein wahrnehmbares Störgeräusch verursachen. An Stellen hoher Störungsdichte, die immer wieder bei einem Aufzeichnungsträger auftreten können, its es sogar möglich, dass mehr als zwei Störungen mit kritischen Abständen vorhanden sind. Daher hat auch in diesen Fällen die Verschachtelung mit ungleichen Abständen durch bessere Fehlerzerstreuung wesentliche Vorteile.

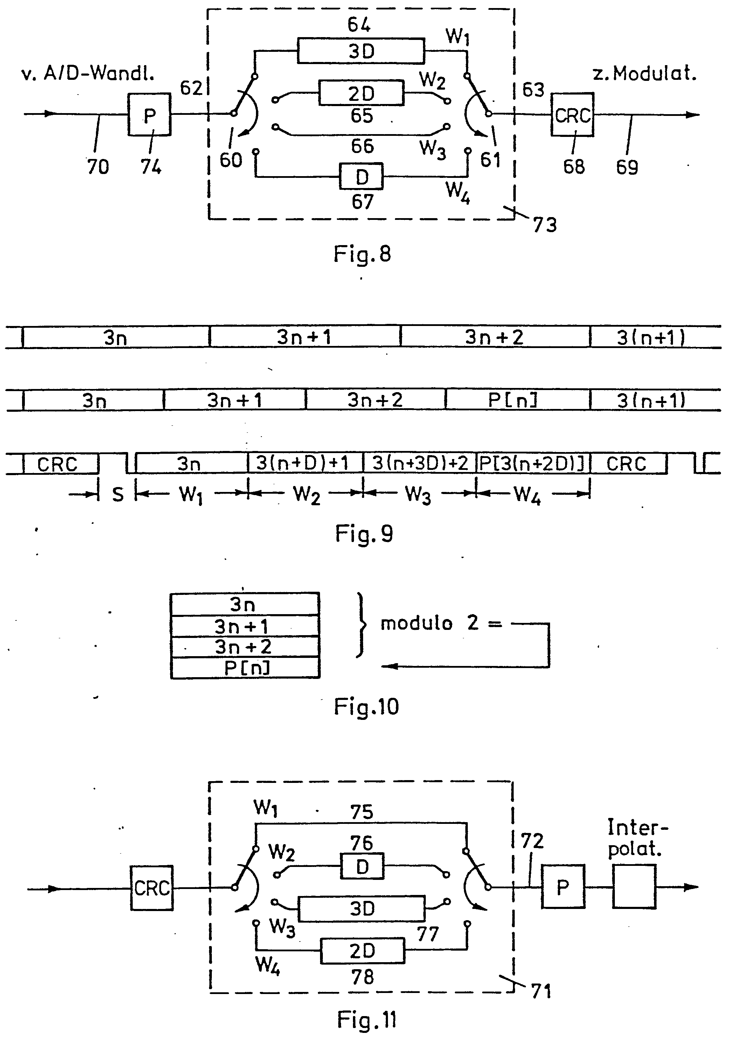

Bei dem bisher dargestellten Verfahren wurde eine Fehlerbeseitigung durch Interpolation durchgeführt. Wenn statt dieser angenäherten Fehlerbeseitigung eine echte Fehlerkorrektur erfolgen soll, so ist das bisher dargestellte Verfahren nicht ausreichend. Mit Hilfe eines Paritätswortes, das z. B. aus jeweils drei aufeinanderfolgenden Abtastwertepaaren gebildet wird, kann eine echte Fehlerkorrektur vorgenommen werden. Dazu wird der Interleavingschaltung 73 von Fig. 8 eine Paritätsschaltung 74 vorgeschaltet, die drei aufeinanderfolgenden Abtastwerten ein Paritätswort anhängt. Das Paritätswort eines Abtasttripels mit der Blocknumerierung n wird entsprechend Fig. 10 bitweise durch modulo-2-Addition der einzelnen Abtastworte gebildet. Das Paritätswort wird in gleicher Weise behandelt wie die Abtastwörter und daher in der Interleavingschaltung 73 ebenfalls der Verschachtelung unterworfen. Die Interleavingschaltung 73 enthält dazu zwei Umschalter 60 und 61, die synchron nacheinander entsprechend dem Auftreten der Abtastworte $W_1$ bis $W_3$ und des Abtastwortes $W_4$ den Eingang 62 und den Ausgang 63 an die Strecken 64, 65, 66 und 67 anlegen. Die Strecke 64 hat dabei die Verzögerung 3D, die Strecke 65 die Verzögerung 2D, die Strecke 66 keine Verzögerung, die Strecke 67 die Verzögerung D. Durch diese Anordnung besitzen die drei eigentlichen Datenwörter die Verzögerungen 3D, 2D und Null, d. h. die Verschachtelungsabstände sind unterschiedlich, sie betragen nämlich zwischen $W_1$ und $W_2$ D und zwischen $W_2$ und $W_3$ 2D. Für das redundante Wort P wird dann der noch nicht benutzte Verzögerungswert D verwendet. Insgesamt werden also wie bei bereits bekannten Anordnungen die Verzögerungszeiten Null, D, 2D und 3D angewendet, jedoch wird durch die geänderte Zuordnung eine bessere Fehlerzerstreuung für die eigentlichen Datenwörter erreicht. Der Aufwand an Verzögerungsmitteln für die Verschachtelung ist also der gleiche wie bei den bekannten Anordnungen. Er wird aber hier wirkungsvoller eingesetzt.

Fig. 9 zeigt in der ersten Zeile das Datenmuster, wie es am Eingang 70 der Paritätsschaltung 74 ankommt. In der Paritätsschaltung 74 wird jedem Abtasttripel n ein Paritätswort P (n) angefügt. Die jetzt vorliegenden vier Worte jedes Blockes werden in der Interleavingschaltung 73 derart verschachtelt, dass das Datenmuster nach Verlassen des CRC-Schaltkreises 68 am Ausgang 69 das Datenmuster entsprechend Fig. 9, dritte Zeile, hat.

In Fig. 11 ist eine Deinterleavingschaltung 71 dargestellt, die komplementär zur Interleavingschaltung 73 aufgebaut ist. Die Gesamtverzögerung vom Eingang 62 der Interleavingschaltung 73 bis zum Ausgang 72 der Deinterleavingschaltung 71 beträgt für alle Abtastworte 3D. Zwischen den einzelnen Abtastworten bestehen ungleiche Verschachtelungsabstände.

Ein derartig aufgebautes Signalverarbeitungssystem ermöglicht eine hohe Übertragungsgüte mit Fehlerzerstreuung, Fehlererkennung und Fehlerkorrektur. Es verbleiben somit nun sehr kleine Restfehler, die ausserhalb des normal Wahrnehmbaren liegen.

## Patentansprüche

1. System zur Verarbeitung und/oder Übertragung von PCM-Signalen über einen Kanal (14, 15, 16), insbesondere von Tonsignalen, die auf einem Magnetband oder einer Platte gespeichert werden, wobei auf der Eingangsseite des Kanals eine Anzahl von ankommenden Datenwörtern des PCM-Signals, die gedanklich zu Datenblöcken zusammengefaßt werden können, mittels einer Schaltungsanordnung (11, 58, 73) zur Verschachtelung nachfolgend zyklisch anderen Datenblöcken zugeordnet werden, auf der Ausgangsseite des Kanals nach der Entschachtelung mittels einer weiteren Schaltungsanordnung (19, 59, 71) die Datenwörter in der ursprünglichen Reihenfolge vorliegen, dadurch gekennzeichnet, daß ein Datenblock wenigstens drei eigentliche Datenwörter des PCM-Signals umfaßt und daß aufeinanderfolgende Datenwörter zyklisch so verschachtelt über den Kanal übertragen werden, daß alle Verschachtelungsabstände zwischen den eigentlichen Datenwörtern verschieden sind.

2. System nach Anspruch 1, dadurch gekennzeichnet, dass die Verschachtelung bzw. Entschachtelung durch unterschiedliche Verzögerung der einzelnen Datenwörter erreicht wird.

3. System nach Anspruch 2, dadurch gekennzeichnet, dass die Schaltungsanordnung zur Verschachtelung ankommender Datenwörter bzw. zur Entschachtelung in die ursprüngliche Reihenfolge als Verzögerungseinrichtungen (58, 59, 73, 71) realisiert sind.

4. System nach Anspruch 3, dadurch gekennzeichnet, dass ein Datenblock drei Datenwörter umfasst und dass zur Verschachtelung bzw. Entschachtelung die Verzögerungseinrichtungen (58, 59, 73, 71) im Dreierzyklus synchron mit dem Auftreten von Datenwörtern umgeschaltet werden.

5. System nach Anspruch 4, dadurch gekennzeichnet, dass bei Einhaltung des Dreierzyklus jedes Datenwort mit der Numerierung 3n um eine Dauer $D_2$, jedes Datenwort mit der Numerierung $3n + 1$ um die Dauer $D_2 - D_1$ und jedes Datenwort mit der Numerierung $3n + 2$ nicht verzögert wird, wobei $D_2$ ungefähr gleich oder gleich $3D_1$ ist (Fig. 6).

6. System nach Anspruch 4, dadurch gekennzeichnet, dass bei Einhaltung des Dreierzyklus jedes Datenwort mit der Numerierung 3n nicht, jedes Datenwort mit der Numerierung $3n + 1$ um die Dauer $D_1$ und jedes Datenwort mit der Numerierung $3n + 2$ und die Dauer $D_2$ verzögert wird (Fig. 6).

7. System nach Anspruch 3, dadurch gekennzeichnet, dass für die Verzögerungseinrichtungen (48-50, 55-57, 64-67, 75-78) ein RAM(Random Access Memory)-Schaltkreis verwendet wird.

8. System nach Anspruch 1, dadurch gekennzeichnet, dass den verschachtelten Datenwörtern blockweise ein Fehlererkennungswort (CRC) und ein Synchronisationswort (Sync) angehängt wird.

9. System nach Anspruch 1, dadurch gekennzeichnet, dass jedes Datenwort aus einem Abtastwertepaar bzw. Abtastwertequartett besteht.

10. System nach Anspruch 1, dadurch gekennzeichnet, dass zusätzlich jedem Datenblock vor der Verschachtelung ein Paritätswort, das aus einer modulo-2-Addition der einzelnen Datenbits der Datenwörter eines Datenblocks gebildet wird, angehängt wird.

11. System nach den Ansprüchen 3 und 10, dadurch gekennzeichnet, dass jeweils drei Datenwörter und ein Paritätswort zu einem Datenblock zusammengefasst werden und dass die Umschaltung der Verzögerungseinrichtungen (58, 59, 73, 71) im Viererzyklus mit dem Auftreten von Datenwörtern erfolgt.

12. System nach Anspruch 11, dadurch gekennzeichnet, dass alle Datenwörter mit der Numerierung 3n um 3D, alle Datenwörter mit der Numerierung $3n + 1$ um 2D, alle Datenwörter mit der Numerierung $3n + 2$ nicht und alle Paritätswörter um D verzögert werden.

13. System nach Anspruch 11, dadurch gekennzeichnet, dass alle Datenwörter mit der Numerierung 3n nicht, alle Datenwörter mit der Numerierung $3a + 1$ um D, alle Datenwörter mit der Numerierung $3n + 2$ um 3D und alle Paritätswörter um 2D verzögert werden.

14. System nach den Ansprüchen 5 oder 6, dadurch gekennzeichnet, dass die Verzögerung $D_2$ der Dauer von 47 Datenblöcken zu jeweils 3 Datenwörtern, die Verzögerung $D_1$ der Dauer von 15 Datenblöcken zu jeweils 3 Datenwörtern entspricht.

15. System nach den Ansprüchen 12 oder 13, dadurch gekennzeichnet, dass die Verzögerung D der Dauer von 16 Datenblöcken zu jeweils 3 Datenwörtern entspricht.

**Claims**

1. System for the processing and/or transmission of PCM-Signals via a channel (14, 15, 16), especially sound signals, which are stored on a magnetic tape or a plate, in which there are allocated to the input side of the channel a number of incident data words of the PCM-Signal, which can notionally be summarised as data blocks, by means of a circuit arrangement (11, 58, 73) for the interleaving of other subsequent cyclic data blocks, and at the output side of the channel after deinterleaving by means of a further circuit arrangement (19, 59, 71) the data words emerge in the original sequence, characterised in that a data block comprises at least three actual data words of the PCM-Signal and in that successive data words are cyclically transmitted via the channel in such an interleaved manner that all interleaving spacings between the actual data words are different.

2. System according to claim 1, characterized in that the interleaving or deinterleaving is achieved by means of different delays of the individual data words.

3. System according to claim 2, characterized in that the circuit arrangements for the interleaving of incident data words or the deinterleaving into the original sequence are realised as delay devices (58, 59, 73, 71).

4. System according to claim 3, characterized in that a data block includes three data words and that the delay devices (58, 59, 73, 71) for producing the interleaving or deinterleaving are switched in the three fold cycle synchronously with the occurrence of data words.

5. System according to claim 4, characterized in that on stepping through the three fold cycle each data word identified by the numeration 3n is delayed by an interval $D_2$, each data word identified by the numeration $3n + 1$ is delayed by an interval $D_2 - D_1$, and each data word identified by the numeration $3n + 2$ is not delayed, $D_2$ being equal or almost equal to $3D_1$ (Fig. 6).

6. System according to claim 4, characterized in that on stepping through the three fold cycle each data word identified by the numeration 3n is not delayed, each data word identified by the numeration $3n + 1$ is delayed by the interval $D_1$, and each data word identified by the numeration $3n + 2$ is delayed by the interval $D_2$ (Fig. 6).

7. System according to claim 3, characterized in that a RAM (Random Access Memory) switching circuit is used for the delay devices (48-50, 55-57, 64-67, 75-78).

8. System according to claim 1, characterized in that an error recognition word (CRC) and a synchronisation word (Sync) are added blockwise to the interleaved data words.

9. System according to claim 1, characterized in that each data word consists of a pair of sample values or quartet of sample values.

10. System according to claim 1, characterized in that additionally there is added to each data block, prior to the interleaving, a parity word which is formed by a modulo-2-addition of the individual data-bits of the data words of a data block.

11. System according to claims 3 and 10, characterized in that three data words and a parity word respectively are brought together as a data block and that the switching of the delay devices (58, 59, 73, 71) occurs in a four fold cycle with the appearance of the data words.

12. System according to claim 11, characterized in that all data words identified by the numeration 3n are delayed by 3D, all data words identified by the numeration $3n + 1$ are delayed by 2D, all data words identified by the numeration $3n + 2$ are not delayed, and all parity words are delayed by D.

13. System according to claim 11, characterized in that all data words identified by the numeration 3n are not delayed, all data words identified by the numeration $3n + 1$ are delayed by D, all data words identified by the numeration $3n + 2$ are delayed by 3D, and all parity words are delayed by 2D.

14. System according to the claims 5 or 6, characterized in that the delay $D_2$ corresponds to the duration of 47 data blocks of respectively 3 data words, the delay $D_1$ corresponds to the duration of 15 data blocks of respectively 3 data words.

15. System according to claims 12 or 13, characterized in that the delay D corresponds to a duration of 16 data blocks of respectively 3 data words.

**Revendications**

1. Système de traitement et/ou de transmission de signaux MIC par une voie (14, 15, 16), en particulier de signaux audio, qui sont enregistrés sur une bande magnétique ou un disque, dans lequel plusieurs mots de données arrivant du signal MIC, pouvant être considérés comme réunis en blocs de données, sont coordonnés successivement et cycliquement, côté entrée de la voie, par un montage d'entrelacement (11, 58, 73), à d'autres blocs de données, et sont restitués dans l'ordre initial, à la sortie de la voie, après restitution par un autre montage (19, 59, 71), caractérisé en ce qu'un bloc de données comprend au moins trois mots de données proprement dits du signal MIC et que des mots de données successifs sont transmis par la voie, en étant entrelacés cycliquement, de manière que tous les intervalles d'entrelacement entre les mots de données proprement dits diffèrent.

2. Système selon revendication 1, caractérisé en ce que l'entrelacement et la restitution sont obtenus par un retard différent des différents mots de données.

3. Système selon revendication 2, caractérisé en ce que les circuits d'entrelacement des mots de données incidents et de restitution dans l'ordre initial sont réalisés sous forme de lignes de retard (58, 59, 73, 71).

4. Système selon revendication 3, caractérisé en ce qu'un bloc de données comprend trois mots de données ; et les lignes de retard (58, 59, 73, 71) d'entrelacement ou de restitution sont commutées selon un cycle ternaire, au synchronisme avec l'apparition de mots de données.

5. Système selon revendication 4, caractérisé en ce qu'avec le cycle ternaire, chaque mot de données numéroté 3n est retardé d'une durée $D_2$, chaque mot de données numéroté $3n + 1$ d'une durée $D_2 - D_1$ et chaque mot de donnée numéroté $3n + 2$ d'une durée nulle, $D_2$ étant sensiblement égale ou égale à $3D_1$ (fig. 6).

6. Système selon revendication 4, caractérisé en ce qu'avec le cycle ternaire, chaque mot de données numéroté 3n n'est pas retardé, chaque mot de données numéroté $n + 1$ est retardé de la durée $D_1$ et chaque mot de données numéroté $3n + 2$ de la durée $D_2$ (fig. 6).

7. Système selon revendication 3, caractérisé par l'emploi d'un circuit intégré RAM (mémoire vive) pour les lignes de retard (48-50, 55-57, 64-67, 75-78).

8. Système selon revendication 1, caractérisé en ce qu'un mot d'identification d'erreur (CRC) et un mot de synchronisation (SYNC) sont ajoutés bloc par bloc aux mots de données entrelacés.

9. Système selon revendication 1, caractérisé en ce que chaque mot de données est constitué par une paire ou une tétrade de valeurs échantillonnées.

10. Système selon revendication 1, caractérisé en ce qu'un mot de parité, formé par addition modulo 2 des divers bits des données des mots d'un bloc de données, est ajouté en outre à chaque bloc de données avant l'entrelacement.

11. Système selon revendications 3 et 10, caractérisé en ce que trois mots de données et un mot de parité sont réunis en un bloc de données ; et la commutation des dispositifs de retard (58, 59, 73, 71) s'effectue selon un cycle quaternaire avec l'apparition des mots de données.

12. Système selon revendication 11, caractérisé en ce que tous les mots de données numérotés 3n sont retardés de 3D, tous les mots de données numérotés 3n + 1 de 2D, tous les mots de données numérotés 3n + 2 d'une durée nulle et tous les mots de parité de D.

13. Système selon revendication 11, caractérisé en ce que tous les mots de données numérotés 3n présentent un retard nul, tous les mots de données numérotés 3n + 1 de D, tous les mots de données numérotés 3n + 2 de 3D et tous les mots de parité de 2D.

14. Système selon une des revendications 5 et 6, caractérisé en ce que le retard $D_2$ correspond à la durée de 47 blocs de données comprenant chacun 3 mots de données, et le retard $D_1$ à la durée de 15 blocs de données comprenant chacun 3 mots de données.

15. Système selon une des revendications 12 ou 13, caractérisé en ce que le retard D correspond à la durée de 16 blocs de données comprenant chacun 3 mots de données.

EP 0 042 522 B2

Fig. 1

Fig. 2

Fig. 3

Fig. 4

Fig. 5

Fig. 6

Fig.7

EP 0 042 522 B2

Fig. 8

Fig. 9

Fig. 10

Fig. 11

3